**Europäisches Patentamt**

**European Patent Office**

**Office européen des brevets**

(19)

(11) Numéro de publication : **0 012 094**
**B1**

(12)

# FASCICULE DE BREVET EUROPÉEN

(45) Date de publication du fascicule du brevet :
**17.03.82**

(51) Int. Cl.³ : **H 05 K 3/02**

(21) Numéro de dépôt : **79400969.6**

(22) Date de dépôt : **05.12.79**

---

(54) **Perfectionnements aux procédés et installations de fabrication de supports cuivrés pour circuits imprimés.**

---

(30) Priorité : **05.12.78 FR 7834248** .

(43) Date de publication de la demande :
**11.06.80 (Bulletin 80/12)**

(45) Mention de la délivrance du brevet :
**17.03.82 Bulletin 82/11**

(84) Etats contractants désignés :
**BE DE GB IT NL SE**

(56) Documents cités :
**FR - A - 1 551 694**
**GB - A - 1 149 339**

(73) Titulaire : **CONSTRUCTIONS MECANIQUES ELECTRI-
QUES ET ELECTRONIQUES DE LIMOURS
4, rue de Presbourg
F-75016 Paris (FR)**

(72) Inventeur : **Coillard, Christian
28, rue Van Gogh Les Gatines
F-78370 Plaisir (FR)**

(74) Mandataire : **Fort, Jacques et al
CABINET PLASSERAUD 84, rue d'Amsterdam
F-75009 Paris (FR)**

Imprimerie Jouve, 18, rue St-Denis, 75001 Paris, France

**Perfectionnements aux procédés et installations de fabrication de supports cuivrés pour circuits imprimés**

La présente invention concerne la fabrication de supports cuivrés pour circuits imprimés. On sait que ces supports se présentent sous forme d'une plaque isolante en résine synthétique renforcée par de la fibre de verre, recouverte sur une face ou sur les deux faces par une mince couche de cuivre.

On connaît un procédé de réalisation d'un stratifié recouvert de cuivre pouvant être utilisé dans le domaine des circuits imprimés (brevet FR-A 1 551 694), suivant lequel on obtient le support stratifié par empilage d'un certain nombre de pièces de tissu de verre imprégné de résine. L'empilage est ensuite placé sur un film de cuivre revêtu de résine auquel il est lié au cours d'une opération de pressage à l'aide de plateaux chauffés. L'invention vise à fournir un procédé et un dispositif de fabrication en continu et économique permettant d'obtenir de tels supports stratifiés.

Dans ce but, l'invention propose notamment un procédé de fabrication de supports cuivrés suivant lequel on dépose successivement, sur une bande de cuivre, une ou plusieurs bandes de fibre de verre et une ou plusieurs couches de résine thermodurcissable, on essore sous faible pression le sandwich ainsi constitué. On le recouvre d'une bande de cuivre ou de matière synthétique suivant qu'on veut constituer un support cuivré sur les deux faces ou sur une seule, et on polymérise la résine dans un four en continu.

Les apports de fibre de verre et de résine sont prévus pour que le produit final comporte au moins 50 % de résine en poids, de façon que le support présente une stabilité dimensionnelle satisfaisante, même lorsqu'il est soumis à soudure à la vague ou par refusion.

On choisira une résine dont la durée de polymérisation dans le four est inférieure à une dizaine de minutes, et avantageusement de quelques minutes. On peut notamment utiliser à cet effet les résines époxy, bien que certaines résines polyester, polyimide et époxy phénoliques conviennent également. La pression d'essorage sera avantageusement de l'ordre du bar. La résine sera choisie pour être moulable sous une pression inférieure à 20 bars, le dépassement de cette valeur impliquant l'emploi de fours de réalisation coûteuse.

L'invention propose également une installation de mise en œuvre du procédé ci-dessus, comprenant des moyens pour faire circuler une bande de cuivre destinée à constituer l'une des faces du support suivant un plan sensiblement horizontal, des moyens situés en des postes répartis le long de la bande de cuivre pour déposer successivement sur celle-ci au moins une bande de fibre de verre et au moins une couche de résine thermodurcissable, des moyens d'essorage sous faible pression, tels que des rouleaux entre lesquels circulent le sandwich constitué par le cuivre, les bandes de fibre de verre et la résine, des moyens pour dérouler, sur le sandwich, en aval du poste d'essorage, une bande de cuivre ou de matière plastique isolante, et un four en continu de polymérisation de la résine.

L'invention sera mieux comprise à la lecture de la description qui suit d'une installation qui en constitue un mode particulier d'exécution, donné à titre d'exemple non limitatif, ainsi que du procédé qu'elle met en œuvre.

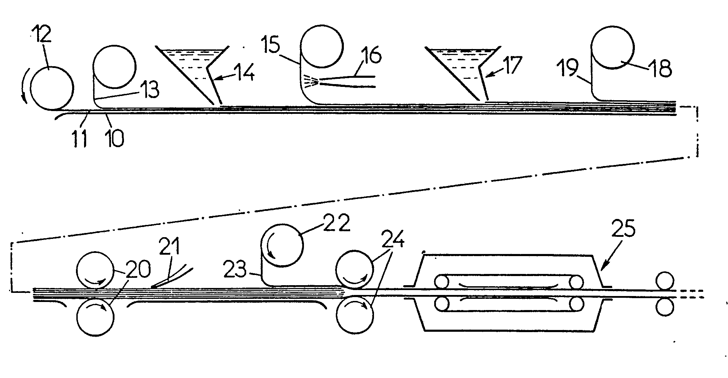

La description se réfère à la figure unique qui l'accompagne et montre, de façon très schématique, la disposition des postes successifs de l'installation. Sur cette figure, l'échelle n'est évidemment pas respectée et, en particulier, les épaisseurs sont très exagérées.

L'installation comporte une table 10 sur laquelle circule une bande de cuivre 11 provenant d'un rouleau débiteur 12. Etant donné que l'on recherchera en général à constituer un support de constitution standard, la bande de cuivre aura 35 microns d'épaisseur environ.

Sur la bande 11, on dépose, en un premier poste de travail, une bande 13 de tissu de fibre de verre, avantageusement de même largeur que la bande de cuivre. Dans le cas le plus général, où l'on voudra constituer un support comprenant plusieurs couches de fibre de verre, on utilisera un tissu à faible grammage, par exemple 200 g/m². De tels tissus de verre à maille fine sont disponibles dans le commerce.

Le poste de travail suivant comporte une goulotte 14 destinée à déposer une couche de résine thermodurcissable sur la bande de tissu 13. A la résine sera généralement ajouté un catalyseur de polymérisation. On connaît divers dispositifs de revêtement permettant de réaliser des couches minces et il n'est pas nécessaire de les décrire ici. La résine se présentera en effet généralement sous forme d'un liquide susceptible de s'étaler facilement.

La bande de tissu 13 déposée à l'état sec s'imprègne de résine et foisonne. Au poste de travail suivant, on dépose une nouvelle couche de fibre de verre. Cette couche devant être emprisonnée entre des bandes de tissu, on pourra généralement la constituer, non pas par un tissu, mais par une bande 15 de « mat ». Pour augmenter la teneur en fibre de verre, la bande 15 de mat peut recevoir, avant d'être déposée, une teneur supplémentaire de verre sous forme de fibres coupées, projetées par un pistolet 16. Le mat et la fibre de verre s'imprègnent de l'excédent de résine déjà déposée.

Au poste de travail suivant, on trouve, dans le mode d'exécution montré sur la figure, une goulotte 17 de dépôt d'une nouvelle couche de la même résine que celle provenant de la goulotte 14.

On peut prévoir des postes supplémentaires de dépôt de bandes de « mat » et éventuellement de résine. Dans le mode d'exécution illustré, qui ne comporte que trois bandes de fibre de verre, au poste de travail suivant on trouve une bobine 18 d'apport d'une bande 19 de tissu de fibre de verre, similaire à la bande 13.

Le sandwich ainsi constitué contiendra généralement un excès de résine. Cet excès de résine est chassé latéralement en faisant passer le sandwich entre deux rouleaux d'essorage 20 qui le soumettent à une faible pression, généralement de l'ordre du bar. Les rouleaux d'essorage remplissent deux autres fonctions. D'une part, ils participent à l'avancement du sandwich. D'autre part, ils assurent la cohésion et l'adhésion intime des différentes couches du sandwich. La résine qui peut avoir reflué en surface, du côté du sandwich non revêtu par du cuivre, peut être collectée par une raclette 21 et recyclée.

Enfin, le dernier constituant du support est amené à un poste de travail qui comporte un rouleau 22 qui dépose sur le sandwich une feuille 23 de cuivre de 35 microns (cas d'un support double face) ou une feuille mince de matériau plastique pelable tel que le « Mylar » (cas d'un support dit simple face).

La feuille ainsi constituée est comprimée, sous une pression supérieure à celle fournie par les rouleaux d'essorage 20, par une batterie de rouleaux 24 (deux rouleaux seulement étant représentés). Les rouleaux 24 chassent latéralement les bulles d'air résiduel emprisonnées par la résine et la fibre de verre. L'utilisation de tissu pour constituer les couches externes de fibres de verre permet d'éviter que les bulles n'entraînent avec elles une quantité importante de fibres de verre coupées, ce qui se traduirait par une diminution corrélative de la teneur globale de l'isolant en fibre de verre.

Enfin, la résine est polymérisée dans un four 25 fonctionnant en continu, où elle est soumise à une pression qui reste modérée pouvant atteindre 20 bars. La durée de polymérisation de la résine sera choisie pour réaliser un compromis entre des exigences dans une certaine mesure opposées : une courte durée de polymérisation se traduit en général par un manque de stabilité dimensionnelle du support ; une durée longue de polymérisation augmente considérablement l'investissement requis.

Dans la pratique, on adoptera en général une durée de polymérisation inférieure à 10 mn. Si le four est prévu pour maintenir le produit sous pression, celle-ci ne dépassera pas 20 bars. Elle peut ainsi être obtenue avec des fours utilisant des chenillettes de maintien en pression du produit ou des rouleaux successifs.

L'invention est évidemment susceptible de nombreuses variantes de réalisation.

En particulier, le nombre de bandes de fibres de verre peut être augmenté, notamment à 6 pour correspondre à celui des bandes dans les supports normalisés de 1,6 mm actuels et des rouleaux intercalaires d'avance ou de précompression peuvent être ajoutés à l'installation. Des moyens de régulation peuvent être prévus pour régler automatiquement la vitesse d'avance des rouleaux de déroulement des bandes et d'entraînement.

Dans le cas où on recherche un produit de coût aussi faible que possible, l'installation et le procédé peuvent être simplifiés. La bande de cuivre, sous laquelle peut être disposée une bande de « Mylar », peut recevoir une seule couche de résine polymérisable contenant des charges minérales, puis une seule bande de fibre de verre. Cette dernière peut être réalisée en faisant tomber en pluie, sur la couche, de la fibre de verre coupée à une longueur de quelques centimètres. La résine peut notamment être dans ce cas une résine polyester, représentant au moins 50 % du composite, à laquelle s'ajoutent des charges minérales classiques, telles que du carbonate de calcium, représentant par exemple, 35 % du composite. On voit que l'installation correspondante se différencie notamment de celle montrée sur la figure unique en ce qu'au premier poste de travail on dépose la couche de la résine polymérisable et non pas la fibre de verre. Une seconde feuille de cuivre est déroulée sur la bande de fibre de verre si on veut constituer un support double face. Une feuille mince de « Mylar » est utilisée pour recouvrir l'ensemble. La polymérisation peut alors s'effectuer dans un four sans maintien en pression mécanique. Les pellicules de « Mylar » sont finalement arrachées.

## Revendications

1. Procédé de fabrication en continu de support cuivré pour circuits imprimés, caractérisé en ce qu'on dépose successivement, sur une bande de cuivre en circulation, au moins une bande de fibre de verre (13) et au moins une couche de résine thermodurcissable, on essore sous faible pression le sandwich ainsi constitué, on le recouvre d'une bande (23) de cuivre ou de matière synthétique et on polymérise la résine dans un four en continu (25) à travers lequel on fait circuler l'ensemble.

2. Procédé suivant la revendication 1, caractérisé en ce que les apports de fibre de verre et de résine sont commandés de façon que le produit final comporte au moins 50 % de résine en poids.

3. Procédé suivant la revendication 1 ou 2, caractérisé en ce que la nature de la résine et la température du four sont choisies pour que la durée de polymérisation soit inférieure à 10 minutes.

4. Procédé suivant l'une quelconque des revendications 1 à 3, caractérisé en ce que l'ensemble du sandwich et de la bande de revêtement est maintenu dans le four sous une pression supérieure à la pression d'essorage, ne dépassant pas 20 bars.

5. Installation de fabrication en continu de supports cuivrés pour circuits imprimés, caractérisée en ce qu'elle comprend des moyens (12, 10) pour faire circuler en continu une bande de cuivre destinée à constituer l'une des faces du support suivant un plan sensiblement horizontal, des moyens (13, 18) situés en des postes répartis le long de la bande de cuivre pour déposer successivement sur celle-ci au moins une bande de fibre de verre et une couche de résine thermodurcissable, des moyens (20, 24) d'essorage sous faible pression traversés par le sandwich constitué par le cuivre, les bandes de fibre de verre et la résine, des moyens (23) pour déposer sur le sandwich, éventuellement en aval des moyens d'essorage, une bande de cuivre ou de matière plastique isolante et un four en continu (25) de polymérisation de la résine.

6. Installation suivant la revendication 5, caractérisée en ce que les moyens (13, 15, 18) de dépôt de bandes de fibre de.verre sont intercalés avec les moyens (14, 17) de dépôt de couches de résine le long du trajet de la bande de cuivre.

7. Installation suivant la revendication 5 ou 6, caractérisée en ce qu'une au moins des bandes de fibre de verre est constituée par un mat (15).

8. Installation suivant la revendication 7, caractérisée en ce que les bandes de fibre de verre comportent au moins deux bandes extrêmes de tissu, au moins une bande intermédiaire étant constituée par du mat.

9. Installation suivant la revendication 5 ou 6, caractérisée en ce qu'elle comprend des moyens (16) de dépôt de fibres de verre coupées.

10. Installation suivant l'une quelconque des revendications 5 à 8, caractérisée en ce que le four est muni de moyens de maintien en pression de l'ensemble constitué par le sandwich et la bande de revêtement.

**Claims**

1. Process for continuous manufacturing of a copper coated substrate for printed circuits, characterized in that there are successively deposited, on a circulating copper band, at least a band of glass fiber (13) and at least a layer of heat hardenable resin, the sandwich which is so constituted is squeezed under low pressure, the sandwich is covered with a band (23) of copper or synthetic material and the resin is polymerized in a continuous oven (25) through which the assembly is circulated.

2. Process according to claim 1, characterized in that the deliveries of glass fiber and resin are controlled for the final product to comprise at least 50 % by weight of resin.

3. Process according to claim 1 et 2, characterized in that the nature of the resin and the temperature of the oven are selected for the duration of the polymerisation step to be lower than ten minutes.

4. Process according to any one of claims 1-3, characterized in that the assembly consisting of the sandwich and the cover band is maintained in the oven under a pressure higher than the squeezing pressure, not exceeding 20 bars.

5. Apparatus for continuous manufacturing of copper coated substrates for printing circuits, characterized in that it comprises means (12, 10) for continuously circulating a copper band for constituting one of the faces of the substrate along a substantially horizontal plane, means (13, 18) located at stations distributed along the copper band for successively depositing thereon at least a band of glass fiber and a layer of heat hardenable resin, means (20, 24) for squeezing out under a low pressure through which the sandwich consisting of the copper, the bands of glass fiber and the resin passes, means (23) for laying on the sandwich, possibly downstream of the squeezing means, a band of copper or electrically insulating plastics material, and a continuous oven (25) for polymerizing the resin.

6. Apparatus according to claim 5, characterized in that the means (13, 15, 18) for laying bands of glass fiber are interleaved with the means (14, 17) for depositing resin layers along the path of the copper band.

7. Apparatus according to claim 5 or 6, characterized in that one at least of the bands of glass fiber consists of a mat (15).

8. Apparatus according to claim 7, characterized in that the bands of glass fiber comprise at least two outer bands of fabrics, an intermediary band at least consisting of mat.

9. Apparatus according to claim 5 or 6, characterized in that it comprises means (16) for depositing cut glass fiber.

10. Apparatus according to any one of claims 5-8, characterized in that the oven is provided with means for maintaining the assembly consisting of said sandwich and the coating band under pressure.

**Ansprüche**

1. Verfahren zur kontinuierlichen Herstellung eines mit Kupfer belegten Trägers für gedruckte Schaltungen, dadurch gekennzeichnet, daß man nacheinander auf ein sich bewegendes Kupferband wenigstens ein Glasfaserband (13) und wenigstens eine Schicht eines wärmehärtbaren Harzes aufbringt, daß man die so gebildete Schichtung unter geringem Druck abquetscht, daß man sie mit einem Band (23) aus Kupfer oder aus Kunststoff abdeckt und daß man das Harz in einem Durchlaufofen (25) polymerisiert, durch welchen.man die Gesamtheit hindurchlaufen läßt.

2. Verfahren nach Anspruch 1, dadurch gekennzeichnet, daß die Anteile der Glasfasern und des Harzes so gesteuert werden, daß das fertige Erzeugnis wenigstens 50 Gew.-% Harz enthält.

3. Verfahren nach Anspruch 1 oder 2, dadurch gekennzeichnet, daß die Art des Harzes und die Ofentemperatur so gewählt sind, daß die Polymerisationszeit kleiner als 10 Minuten ist.

4. Verfahren nach einem der Ansprüche 1 bis 3, dadurch gekennzeichnet, daß die aus der Schichtung und dem Abdeckband bestehende Gesamtheit in dem Ofen unter einem Druck gehalten wird, der größer ist als der Abquetschdruck, aber 20 bar nicht überschreitet.

5. Einrichtung zur kontinuierlichen Herstellung von mit Kupfer belegten Trägern für gedruckte Schaltungen, dadurch gekennzeichnet, daß sie Mittel (12, 10) aufweist, um ein Kupferband, das die eine Seite des Trägers bilden soll, kontinuierlich auf einer im wesentlichen horizontalen Ebene zu bewegen, ferner Mittel (13, 18), die an über die Länge des Kupferbandes verteilten Stellen angeordnet sind, um auf dieses nacheinander wenigstens ein Glasfaserband und eine Schicht eines wärmehärtbaren Harzes aufzubringen, Mittel (20, 24) zum Abquetschen mit geringem Druck, die von der durch das Kupfer, die Glasfaserbänder und das Harz gebildeten Schichtung durchquert werden, Mittel (23), um auf die Schichtung, ggf. in Bewegungsrichtung hinter den Abquetschmitteln, ein Band aus Kupfer oder einem isolierenden Kunststoff aufzubringen, und einen Durchlaufofen (25) zur Polymerisation des Harzes.

6. Einrichtung nach Anspruch 5, dadurch gekennzeichnet, daß Mittel (13, 15, 18) zum Aufbringen der Glasfaserbänder mit Mitteln (14, 17) zum Aufbringen der Harzschichten über die Bahnlänge des Kupferbandes miteinander abwechseln.

7. Einrichtung nach Anspruch 5 oder 6, dadurch gekennzeichnet, daß wenigstens ein Glasfaserband durch eine Matte (15) gebildet ist.

8. Einrichtung nach Anspruch 7, dadurch gekennzeichnet, daß die Glasfaserbänder aus wenigstens zwei äußeren Gewebebändern bestehen, wobei wenigstens ein dazwischen angeordnetes Band durch eine Matte gebildet ist.

9. Einrichtung nach Anspruch 5 oder 6, dadurch gekennzeichnet, daß sie Mittel (16) aufweist, um geschnittene Glasfasern aufzubringen.

10. Einrichtung nach einem der Ansprüche 5 bis 8, dadurch gekennzeichnet, daß der Ofen mit Mitteln versehen ist, die die aus der Schichtung und dem Abdeckband bestehende Gesamtheit unter Druck hält.